# EUROPÄISCHE PATENTSCHRIFT

(11) **EP 2 195 693 B1**
(45) Veröffentlichungstag und Bekanntmachung des Hinweises auf die Patenterteilung: **15.02.2017**
(21) Anmeldenummer: 08782849.7
(22) Anmeldetag: 11.09.2008
(51) Int. Cl.: H05K 1/02, G02B 6/43, G02B 6/138, H05K 3/46

(54) **STARR-FLEXIBLES LEITERPLATTENELEMENT UND VERFAHREN ZU DESSEN HERSTELLUNG**
RIGID-FLEXIBLE PRINTED CIRCUIT BOARD ELEMENT AND METHOD FOR THE PRODUCTION THEREOF
CARTE DE CIRCUIT IMPRIME RIGIDE-SOUPLE ET PROCEDE DE PRODUCTION ASSOCIE

(30) Priorität: 21.09.2007 AT 14902007
(43) Veröffentlichungstag der Anmeldung: 16.06.2010
(73) Patentinhaber: AT & S Austria Technologie & Systemtechnik Aktiengesellschaft, 8700 Leoben-Hinterberg (AT)
(72) Erfinder: LANGER, Gregor, A-8010 Graz (AT); STAHR, Johannes, A-8600 Bruck an der Mur (AT)
(74) Vertreter: Sonn & Partner Patentanwälte
(86) Internationale Anmeldenummer: PCT/AT2008/000321
(87) Internationale Veröffentlichungsnummer: WO 2009/036478

(56) Entgegenhaltungen:
- WO-A-2005/064381
- AT-A4- 503 027
- US-A1- 2005 208 431
- US-A1- 2006 198 569
- US-A1- 2006 269 288
- US-A1- 2007 183 718

## Beschreibung

Die Erfindung betrifft ein Starr-flexibles Leiterplattenelement mit zumindest einem starren Leiterplattenteil mit einem optoelektronischen Bauelement das in einer Kavität untergebracht ist. Ein derartiges Leiterplattenelement ist aus US 2006/0198569 A1 bekannt.

Weiters bezieht sich die Erfindung auf ein Verfahren zur Herstellung eines solchen Leiterplattenelements.

Leiterplattenelemente mit starren und flexiblen Leiterplattenteilen wurden im Hinblick auf die Notwendigkeit von falz- bzw. biegefähigen Verbindungen bei den verschiedensten Anwendungen vorgeschlagen, angefangen von Anwendungen für die Montage von LEDs in Stufen, vgl. beispielsweise DE 199 09 399 C1, bis zu Anwendungen derartiger teilweise flexibler Leiterplatten in elektronischen Geräten mit klappbarem Teil, wie Mobiltelefongeräten, aber auch tragbaren Computern (Laptops, Notebooks) und so genannten Handhelds, wo im Hinblick auf Daten- bzw. Signalverbindungen über Scharniergelenke hinweg eine entsprechende Flexibilität gefordert war. Neben der Anwendung für falz- bzw. biegefähige Verbindungen können starr-flexible Leiterplattenelemente auch für so genannte flex-to-install-Applikationen eingesetzt werden, bei welchen der flexible Leiterplattenteil nur einmal gebogen wird, um eine Verbindung zwischen zwei Leiterplatten (z.B. Motherboard, Daughtercard) herzustellen, worauf die flexible Leiterplatte dann in diesem Zustand verbleibt. Der Aufbau von starr-flexiblen Leiterplatten bzw. deren Herstellung ist in verschiedenen Dokumenten beschrieben worden, wie etwa in der oben genannten US 2006/0198569 A1 EP 1 659 840 A1, WO 2005/055685 A1 oder WO 2004/110114 A1. Bei diesen starr-flexiblen Leiterplatten bilden die flexiblen Leiterplattenteile eine Art (Film)-Scharniergelenk zwischen starren Leiterplatten, um so eine Schwenkbewegung zwischen den starren Leiterplattenteilen zu ermöglichen. Über die flexiblen Leiterplattenteile führen in herkömmlicher Weise Kupferverbindungen oder aber Lichtwellenleiter.

Es ist bereits bekannt geworden, vgl. etwa die WO 2005/064381 A1, die AT 503 027 B1 oder die US 2002/0028045 A1, optische Signalverbindungen in Leiterplatten zu integrieren.

Damit wird die Funktionalität der Leiterplatten wesentlich erhöht, und es können hochkomplexe Produktapplikationen realisiert werden, wobei eine weitere Miniaturisierung der Leiterplatten, eine Erhöhung der Integrationsdichte von Schaltungsmerkmalen und damit eine höhere Produktwertschöpfung ermöglicht werden. Derartige Leiterplatten mit optischen Verbindungen können dort zum Einsatz kommen, wo die Applikationen die Übertragung von hohen Datenmengen zwischen Bauelementen oder Funktionseinheiten und/oder ein platzsparendes Design der Verbindungsstrecken erfordern. Diese integrierten optischen Verbindungen waren bisher praktisch jedoch auf starre Leiterplatten beschränkt, wenngleich in der vorgenannten US 2002/0028045 A1 bereits eine Ausführungsform mit einer optischen Verbindung auf einem flexiblen Substrat beschrieben wird. An sich ist in diesem Dokument jedoch die Anbringung von optischen Verbindungen auf Mehrkomponenten-Modulen (MCM - Multi Component Modul) und nicht auf Leiterplatten betroffen, und die flexible Leiterplatte wird hier nur beschrieben, um eine flexible Installation und dabei eine optische Verbindung zu einem anderen Modul herstellen zu können, wobei durch die Flexibilität Produktionsungenauigkeiten auszugleichen sind.

Die Erfindung befasst sich nun mit der Aufgabe, die beiden vorstehend genannten Technologien, nämlich einerseits starr-flexible Leiterplattenelemente und andererseits in Leiterplatten integrierte optische Verbindungen, d.h. Licht-Wellenleiter, in einer effizienten Weise miteinander zu verbinden, um so die Vorteile der Übertragung von hohen Datenraten mit geringem Platz- und Abschirmungsaufwand und der Erhöhung der Zuverlässigkeit und Design-Möglichkeiten zu kombinieren und ein neues High-Tech-Leiterplattenelement vorzusehen, das zusätzliche, neue Möglichkeiten am Elektroniksektor bietet.

Ein dabei zu überwindendes Problem ist darin gelegen, eine platzsparende Bauweise und dabei insbesondere eine möglichst geringe Bauhöhe trotz der zusätzlichen Licht-Wellenleiter-Verbindung zu ermöglichen. Vor allem stellt sich hierbei auch das Problem, die Biegsamkeit des Verbund-Leiterplattenelements insgesamt nicht zu beeinträchtigen, sondern nach Möglichkeit die gegebene Flexibilität durch einen sehr dünn gehaltenen flexiblen Leiterplattenteil zumindest beizubehalten oder sogar zu steigern. Anderseits soll den Anforderungen an ein starr-flexibles Leiterplattenelement im üblichen Sinn genügt werden, wobei anstatt der temporären Verbindungen dauerhafte Verbindungen gegeben sind und eine lang andauernde mechanische Beanspruchung, etwa beim Auf- und Zuklappen eines Mobiltelefongeräts oder eines tragbaren Computers, zu ermöglichen ist. Ein Einsatz des starr-flexiblen Leiterplattenelements soll aber auch für temporäre Verbindungen möglich sein. Beispielsweise kann ein starr-flexibles Leiterplattenelement zur temporären Verbindung zweier Leiterplatten in Form eines elektrischen Steckers dienen. Das starr-flexible Leiterplattenelement stellt in diesem Fall ein "optisches Kabel" dar.

Aus der AT 503 027 B1 ist ein Leiterplattenelement mit einem eingebetteten optoelektronischen Bauelement bekannt, das einen integrierten Spiegel zur Umlenkung der Lichtstrahlung aufweist.

Ein Anliegen der Erfindung ist daher im Besonderen darin zu sehen, dass eine optimale Integration der optoelektronischen Bauelemente in einem starr-flexiblen Leiterplattenelement erfolgen soll, um die geringe Bauhöhe sowie die geringe Dicke des flexiblen Leiterplattenteils und somit dessen hohe Flexibilität bei den gewünschten Anwendungen sicherzustellen.

Zur Lösung der gestellten Aufgabe sieht die Erfindung ein Leiterplattenelement sowie ein Herstellungsverfahren wie in Anspruch 1 bzw. Anspruch 16 definiert vor. Vorteilhafte Ausführungsformen und Weiterbildungen sind in den abhängigen Ansprüchen angegeben.

Beim erfindungsgemäßen starr-flexiblen Leiterplattenelement wird dadurch, dass das bzw. jedes optoelektronische Bauelement in einer Kavität im Leiterplattenelement, und zwar vorzugsweise im Verbindungsbereich zwischen einem starren und einem flexiblen Leiterplattenteil, insbesondere bevorzugt im flexiblen Leiterplattenteil, angebracht wird, in effizienter Weise die Anbringung einer Wellenleiterschicht, d.h. einer Schicht aus optischem Material, beispielsweise auf einem gesonderten flexiblen Leiterplattenteil und über dem optoelektronischen Bauelement ermöglicht, ohne dabei die Bauhöhe wesentlich zu vergrößern. Das optoelektronische Bauelement ragt nämlich mit seinem Lichtabgabeteil oder Lichtempfangsteil gerade so weit in die Höhe, dass es sich geringfügig höher als die Oberseite der Kavität oder des flexiblen Leiterplattenteils befindet, über dem die - flexible - Schicht des optischen photopolymerisierbaren Materials angebracht ist. In dieser Schicht aus optischem Material ist der Licht-Wellenleiter in Ausrichtung zum Lichtabgabeteil bzw. Lichtempfangsteil des optoelektronischen Bauelements durch Bestrahlung strukturiert. Für diese Strukturierung wird bevorzugt die in der WO 2005/064381 A1 bereits beschriebene Mehrphotonenabsorptions-Methode angewandt, bei der eine chemische Reaktion, nämlich Polymerisation, durch gleichzeitige Absorption von mehreren - in der Regel zwei - Photonen aktiviert wird. Im Hinblick auf die Zwei-Photonen-Absorption wird dieser Prozess in der Regel auch TPA-Prozess genannt (TPA - Two Photon Absorption; Zwei-Photonen-Absorption). Beispielsweise ist das zu strukturierende optische Material für die verwendete Anregungswellenlänge (z.B. 800 nm) einer Licht-Welle (insbesondere einer Laserquelle) transparent. Daher kommt es im Material zu keiner Absorption und zu keinem Ein-Photonen-Prozess. Im Fokusbereich des Licht- bzw. Laserstrahls ist jedoch die Intensität so hoch, dass das Material zwei (oder mehr) Photonen absorbiert, wodurch eine chemische Reaktion aktiviert wird. Ein Vorteil ist dabei auch, dass durch die Transparenz des optischen Materials für die Anregungswellenlänge alle Punkte in der Schicht erreicht und somit problemlos dreidimensionale Strukturen in der Schicht eingeschrieben werden können. Unter "dreidimensional" ist dabei zu verstehen, dass der Licht-Wellenleiter nicht nur in einer Ebene (x-y-Ebene) verlaufen muss, sondern auch in der Höhe (z-Richtung) variieren kann, d.h. sich in x-, y- und auch z-Richtung erstrecken kann, aber auch, dass der Licht-Wellenleiter in seiner Form über seine Längserstreckung Veränderungen in x-, y- und z-Richtung aufweisen kann, etwa indem der Querschnitt von kreisförmig auf flach elliptisch, wieder auf kreisförmig und auf hochstehend elliptisch wechseln kann.

Der beschriebene Mehr-Photonen-Absorptionsprozess ist ein Einschritt-Strukturierungsprozess, bei dem keinerlei Mehrfachbelichtungen und keinerlei nass-chemische Entwicklungsschritte erforderlich sind.

Im Übrigen kann hier zur weiteren Information auf die WO 2005/064381 A1 verwiesen werden.

Wie erwähnt wird durch die Erfindung erstmals eine Integration eines durch einen Photonen-Absorptionsprozess strukturierten Licht-Wellenleiters in einem starr-flexiblen Leiterplattenelement in effizienter Weise ermöglicht, wobei eine kompakte Anbindung des Licht-Wellenleiters an die vollständig im optischen Material eingebetteten optoelektronischen Bauelemente erzielt und eine hohe Flexibilität im biegsamen Bereich des Hybrid-Leiterplattenelements sichergestellt wird.

Es sei noch erwähnt, dass in der WO 2005/078497 A1 ein - starres - Mehrschicht-Leiterplattenelement beschrieben ist, in dem von der Oberseite her eine Sackloch-artige Vertiefung gebohrt wird, in der danach ein optoelektronisches Bauelement angebracht wird, das mit einem optischen Bus zwischen zwei Isolierschichten kommuniziert. Das Bauelement wird dabei auf einer diskontinuierlichen Metallschicht in der Vertiefung aufgeklebt.

Die Verbindung zwischen dem - insbesondere gesonderten - flexiblen Leiterplattenteil und dem oder den starren Leiterplattenteil(en) kann beim vorliegenden Leiterplattenelement bevorzugt mit Hilfe einer Klebeschicht bewerkstelligt werden. Die Klebeschicht kann beispielsweise durch einen termisch härtenden Kleber, drucksensitiven Kleber, so genannte Prepregs (also nicht ausgehärtete glasfaserverstärkte Epoxidharzschichten) oder dergl. gebildet sein. Hierbei kann ein vorgefertigtes starr-flexibles Leiterplattenelement derart erhalten werden, dass ein noch durchgehender starrer Leiterplattenteil mit einem aufgeklebten flexiblen Leiterplattenteil, z.B. einer Polyimidfolie, versehen wird, wonach ein Bereich des starren Leiterplattenteils durch Herausfräsen, -schneiden oder dgl. Bearbeitung entfernt wird, so dass zumindest ein starrer Leiterplattenteil, vorzugsweise zwei in Abstand voneinander vorliegende starre Leiterplattenteile zurückbleiben, wobei der bzw. jeder starre Leiterplattenteil mit dem flexiblen Leiterplattenteil über die Klebeschicht verbunden ist. In diesem so erhaltenen vorgefertigten Leiterplattenelement, das selbstverständlich wie üblich mit Kupferschichten bzw. Kupferleiterbahnen, mit Durchverbindungen etwa in Form von Mikrovias (µ-Vias) und dgl. versehen sein kann, werden dann die Kavitäten oder Hohlräume für die optoelektronischen Bauelemente z.B. durch Fräsen angefertigt, wobei diese Kavitäten insbesondere im flexiblen Leiterplattenteil sowie in der Klebeschicht gebildet werden; demgemäß kann dann das jeweilige eingesetzte und montierte optoelektronische Bauelement mit seiner Basisfläche direkt auf der Oberseite des starren Leiterplattenteils aufsitzen, wobei es dort in üblicher Weise kontaktiert werden kann. Seitlich und an der Oberseite ist das optoelektronische Bauelement in dieser Fertigungsphase noch frei, und wenn danach das optische, photopolymerisierbare Material zur Bildung der optischen Schicht aufgebracht wird, wird das optoelektronische Bauelement rundum und an der Oberseite von diesem optischen Material umschlossen und darin eingebettet. Für diese Anbringung der Schicht des optischen photopolymerisierbaren Materials kann an der Oberseite des Leiterplattenelements zuvor ein flexibler Rahmen angebracht werden, der nach Anbringung der optischen Schicht diese umgibt und das bei der Anbringung viskose optische Material an Ort und Stelle hält. Der flexible Rahmen kann zur Erhöhung der Flexibilität auch nachträglich wieder entfernt werden. Dieser flexible Rahmen kann beispielsweise aus einer Polyimidfolie gebildet sein.

Gemäß einer alternativen Ausführungsform kann die vorstehend erwähnte eigene flexible Substratlage als flexibler Leiterplattenteil weggelassen werden, und der flexible Leiterplattenteil kann durch die optische Schicht selbst gebildet sein. Bei der Herstellung einer derartigen Leiterplatte kann beispielsweise derart vorgegangen werden, dass zunächst nur ein starres Substrat vorliegt, das mit den Kavitäten und den darin angeordneten optoelektronischen Bauelementen sowie anschließend mit der optischen Schicht, in der der Licht-Wellenleiter strukturiert wird, versehen wird, wobei abschließend ein Teil des starren Substrats entfernt wird, so dass z.B. zwischen zwei verbleibenden, beabstandeten starren Leiterplattenteilen nur die durch die optische Schicht allein gebildete flexible Schicht verbleibt.

Das bzw. jedes optoelektronische Bauelement kann mit einem integrierten, an seiner Oberseite angeschlossenen Umlenkspiegel als Lichtabgabeteil oder aber als Lichtempfangsteil ausgebildet sein, und bevorzugt ragt nur dieser Umlenkspiegel über die Oberseite oder obere Kante der Kavität, wogegen das eigentliche optoelektronische Bauelement völlig innerhalb der Kavität, also insbesondere tiefer als die Oberseite des flexiblen Leiterplattenteils liegend, untergebracht ist. Das optoelektronische Bauelement kann beispielsweise ein VCSEL (Vertical Cavity Surface Emitting Laser)-Bauelement sein, es kann sich jedoch dabei auch um ein anderes bekanntes optoelektronisches Bauelement handeln, wie etwa eine Photodiode oder einen Phototransistor, ebenso wie eine Licht emittierende Diode (LED). Der flexible Leiterplattenteil kann selbst ebenfalls herkömmliche Kupferbahnen tragen, die beim fertigen starr-flexiblen Leiterplattenelement in der optischen Schicht eingebettet und geschützt sind.

Die optische Schicht kann mit einer flexiblen Decklage als Schutzschicht versehen und so geschützt werden. Neben einem mechanischen Schutz kann die flexible Decklage auch vor Lichteinstrahlung schützen, um Störungen der Lichtleitung zu unterbinden. Zu diesem Zweck ist die flexible Decklage vorzugsweise gefärbt und absorbiert von außen einstrahlendes Licht. Beispielsweise kann diese Decklage aus Polyimid bestehen.

Grundsätzlich kann das vorliegende starr-flexible Leiterplattenelement auch in weiteren Schritten zu einer Viellagen-Leiterplatte (Multilayer-Leiterplatte) ausgestaltet werden.

Aus den vorstehenden Darlegungen ergibt sich bereits, dass besonders bevorzugt im starr-flexiblen Leiterplattenelement zumindest zwei starre Leiterplattenteile in Abstand voneinander vorgesehen sind, wobei der Abstand oder Raum zwischen diesen beiden starren Leiterplattenteilen von dem flexiblen Leiterplattenteil überbrückt wird; an jedem starren Leiterplattenteil ist ein optoelektronisches Bauelement (ein Sender und ein Empfänger) in einer Kavität angeordnet, und der Licht-Wellenleiter erstreckt sich zwischen diesen beiden optoelektronischen Bauelementen.

Selbstverständlich können aber auch in der vorliegenden starr-flexiblen Hybrid-Leiterplatte in herkömmlicher Weise weitere Bauelemente untergebracht sein.

Die vorliegende Technologie nützt die Vorteile der starr-flexiblen Leiterplatte und der TPA-Strukturierung von Licht-Wellenleitern zur Herstellung von hochintegrierten optischen Signalverbindungen in einem Leiterplattenelement. Durch die vorgeschlagene Technik kann dabei sowohl optisches Material, das in der Regel relativ hochpreisig ist, eingespart, als auch ein sehr dünner und demgemäß hochflexibler Biegebereich des Leiterplattenelements realisiert werden.

Die vorliegende Technik kann in optoelektronischen Hybrid-Leiterplatten mit Multimode- oder Singlemode-Wellenleitern für hohe Datentransferraten und unter Erzielung von großer Designfreiheit eingesetzt werden. Anwendungsgebiete sind beispielsweise optoelektronische Backplanes, Flex- bzw. Rigid-Flex-Leiterplatten etwa für Mobiltelefone oder Laptops und Handhelds. Für derartige Applikationen ist eine hohe Flexibilität und Zuverlässigkeit der flexiblen Verbindung, im Hinblick auf das oftmalige Auf- und Zuklappen, von Bedeutung.

Ein besonderer Vorteil liegt in der Minimierung der Schichtdicke, vor allem auch des optischen Materials, in den flexiblen Bereichen der vorliegenden starr-flexiblen Leiterplattenelemente, was für die starr-flexiblen Leiterplatten mit den vielen scharnierartigen Verbindungsbereichen von besonderer Bedeutung ist.

Die Erfindung wird nachfolgend anhand von bevorzugten Ausführungsbeispielen, auf die sie jedoch nicht beschränkt sein soll, und unter Bezugnahme auf die Zeichnung noch weiter erläutert. Dabei zeigen:
Fig. 1 einen schematischen Querschnitt durch ein starr-flexibles Leiterplattenelement mit einer integrierten optischen Verbindung;
Fig. 2 in einem Fig. 1 vergleichbaren Querschnitt eine demgegenüber etwas modifizierte Ausführungsform eines starr-flexiblen Leiterplattenelements;
die Fig. 2A-2L aufeinanderfolgende Stufen bei der Herstellung eines derartigen Leiterplattenelements gemäß Fig. 2;
die Fig. 3-10 weitere Modifikationen eines starr-flexiblen Leiterplattenelements in Schnitten ähnlich Fig. 1 und 2;
die Fig. 11 und 11A in einem schematischen Schnitt bzw. in einer schematischen Draufsicht eine Ausführungsform eines erfindungsgemäßen Leiterplattenelements mit Licht-Wellenleitung in verschiedenen Höhen; und
Fig. 12 noch eine andere Ausführungsform eines erfindungsgemäßen starr-flexiblen Leiterplattenelements, wobei hier der Einfachheit halber zwei unterschiedliche Funktionen veranschaulicht sind.

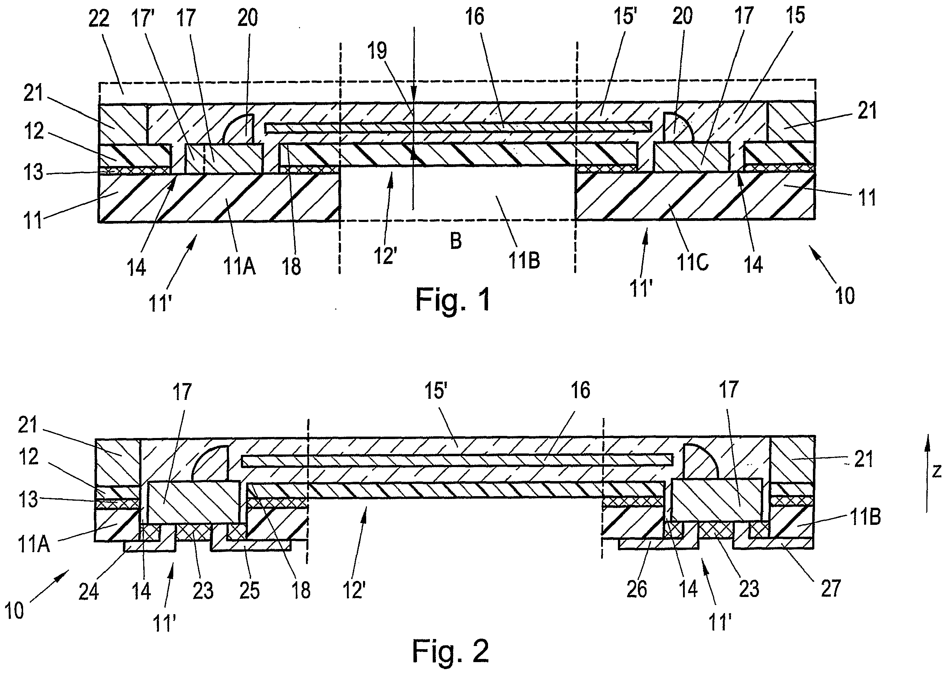

In Fig. 1 ist nur ganz schematisch, ohne maßstäbliche Abbildung der einzelnen Bestandteile, eine starr-flexible Leiterplatte 10 gezeigt, die ein starres Substrat 11 als Basis hat, aus dem zwei starre Leiterplattenteile 11A, 11C gebildet sind; diese starren Leiterplattenteile 11A, 11C definieren zwei starre Bereiche 11' und sind durch einen offenen Bereich B voneinander getrennt, der durch Entfernen eines strichliert angedeuteten Substratteils 11B erhalten wurde, und der durch einen flexiblen Leiterplattenteil 12 überbrückt ist, der eine biegsame Verbindung zwischen den beiden starren Leiterplattenteilen 11A und 11C vorsieht.

Im gezeigten Ausführungsbeispiel ist ein eigener flexibler Leiterplattenteil 12, z.B. eine Polyimidfolie, vorgesehen, der bzw. die mit Hilfe einer Klebeschicht 13 auf den beiden starren Leiterplattenteilen 11A und 11C befestigt ist.

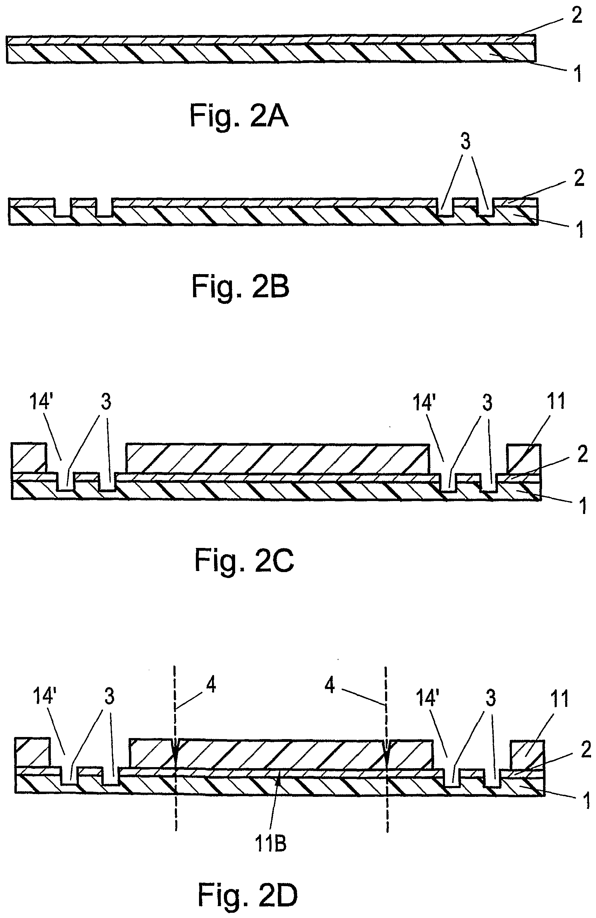

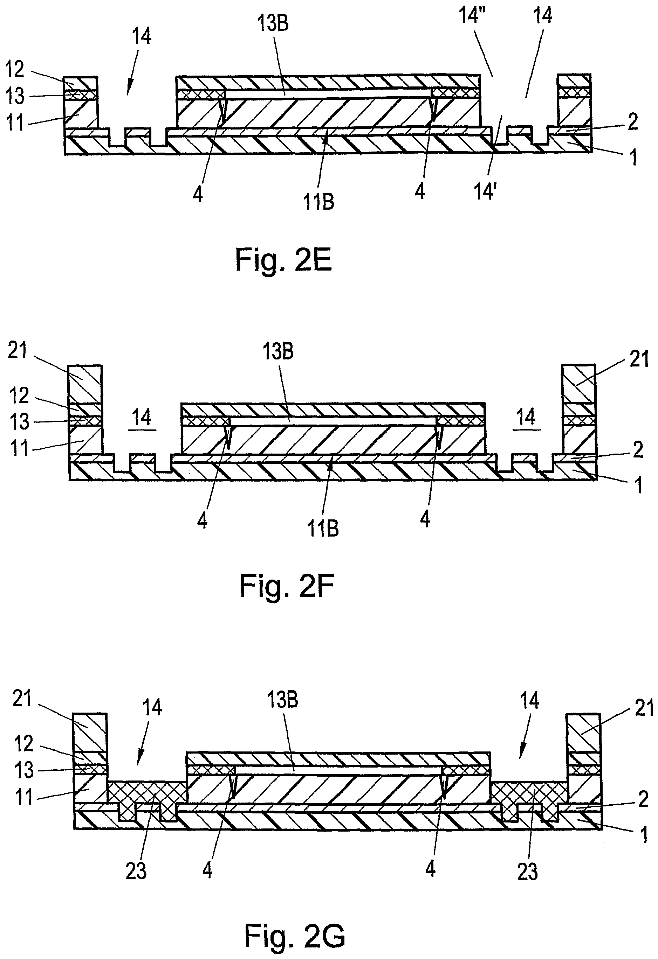

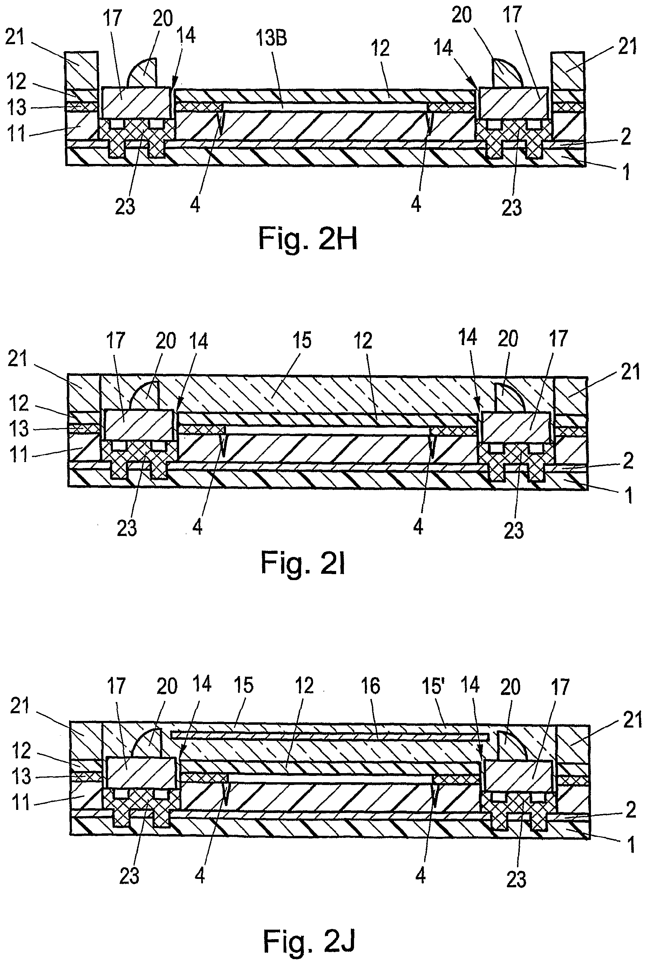

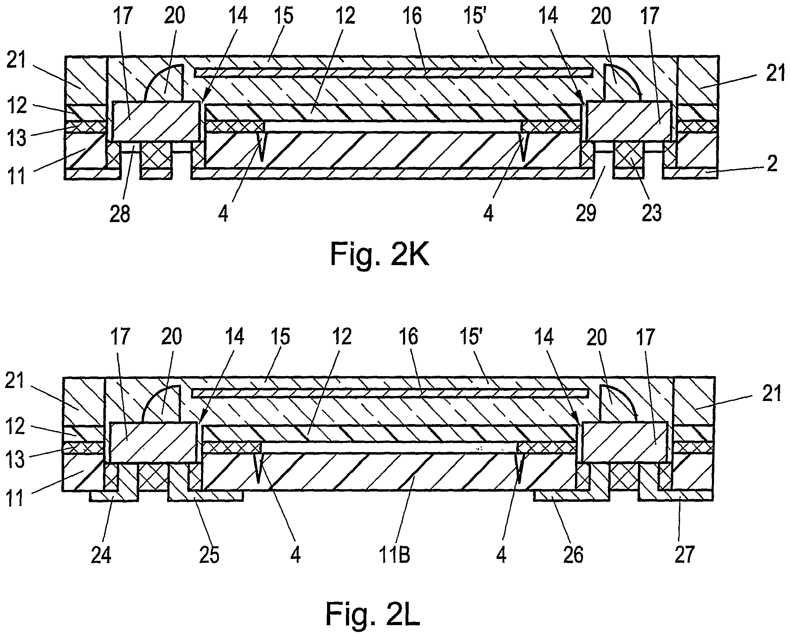

Bei der Herstellung dieses soweit beschriebenen starr-flexiblen Leiterplattenelements 10 kann im Prinzip so, wie nachfolgend in Zusammenhang mit der modifizierten Anführungsform gemäß Fig. 2 anhand der Fig. 2A bis 2L erläutert werden wird, vorgegangen werden. Kurz gesagt kann ein durchgehendes starres Substrat 11, z.B. aus FR4-Material, also einer ausgehärteten, glasfaserverstärkten Epoxidharzplatte, verwendet werden. Die Klebeschicht 13 kann aus einem herkömmlichen Ein- oder Mehrkomponenten-Kleber bestehen, welcher beispielsweise thermisch vernetzend härtbar ist. Es kann jedoch auch ein druckempfindlicher Kleber oder ein thermoplastischer Kleber verwendet werden, wie auch die Klebeschicht 13 aus nicht ausgehärteten Epoxidharzschichten, insbesondere glasfaserverstärkten Epoxidharzschichten (Prepregs) bestehen kann. Das flexible Substrat, für den flexiblen Leiterplattenteil 12, wird über eine derartige Klebeschicht 13 oder Harzschicht auf das starre Substrat 11 verpresst. Sowohl die Klebeschicht 13 als auch der flexible Leiterplattenteil 12 werden vorkonfektioniert eingesetzt, so dass vorgefertigte Kavitäten 14 in bestimmten Bereichen erhalten werden.

Im Anschluss an die Anbringung des flexiblen Leiterplattenteils 12 sowie an weitere Schritte, wie Strukturierung etc., vgl. auch die nachfolgende Beschreibung anhand der Fig. 2 bis 2L wird aus dem starren Substrat 11 im Bereich B der Substratteil 11B herausgenommen, so dass die beiden starren Leiterplattenteile 11A und 11C zurückbleiben. Der Teil, in dem der nun entfernte Substratteil 11B vorgelegen ist, und der nun frei ist, wird vom flexiblen Leiterplattenteil 12 überbrückt, wodurch hier ein biegsamer Verbindungsbereich in der Art eines Filmscharniers erhalten wird, wobei jedoch in diesem flexiblen Verbindungsbereich in der Regel Leitungsverbindungen bestehen.

Insbesondere ist bei der vorliegenden starr-flexiblen Leiterplatte 10 eine optische Verbindung integriert, wobei ein optisches Material 15 als optische Schicht 15' angebracht ist, in dem bzw. in der ein Licht-Wellenleiter 16 beispielsweise auf die Weise, wie in der WO 2005/064381 A1 beschrieben, strukturiert ist. Ein übliches optisches Material 15, für die Bildung der Schicht 15', ist beispielsweise ein anorganisch-organisches Hybridmaterial, wie ein organisch modifiziertes Keramikmaterial, welches mittels eines Sol-Gel-Prozesses hergestellt wird. Ein anderes bekanntes optisches Material ist ein anorganisch-organisches Hybridglas, welches ebenfalls in einem Sol-Gel-Prozess hergestellt wird und mit einem Photoinitiator (Benzyldimethylketal) gedopt ist. Dieses Hybridglas besteht aus Methylacrylat mit einem Silika/Zirkonia-Netzwerk. Weitere bekannte Materialien sind beispielsweise photosensitive Imide bzw. Polyimide, Organo-Silsesquioxane, Silikonkautschuke oder dgl..

Bevor jedoch das optische Material 15 auf der Hybrid-Leiterplatte mit den starren Leiterplattenteilen 11A, 11C und dem flexiblen Leiterplattenteil 12 angebracht wird, werden in den Kavitäten 14 die gewünschten optoelektronischen Bauelemente 17 eingesetzt, die im in Fig. 1 gezeigten Ausführungsbeispiel mit ihren Unterseiten direkt auf den starren Leiterplattenteilen 11A, 11C aufliegen. Die Kontaktierung dieser optoelektronischen Bauelemente 17 kann z.B. in herkömmlicher Weise über Wirebond-Verbindungen (Golddrahtkontaktierungen), aber auch über nachträgliche Mikrovia-Kontaktierungen (Verbindungen mittels verkupferter Laserbohrungen nach der Integration der Bauelemente in der Leiterplatte) oder aber auch mit Hilfe eines Kontaktierungsverfahrens wie in WO 2005/125298 A2 beschrieben erfolgen; in letzterem Fall wären die Kavitäten 14 auch in den starren Leiterplattenteilen 11A, 11C vorhanden, vgl. auch die nachfolgend zu beschreibenden Fig. 2 und 2A bis 2L.

Als optoelektronische Bauelemente 17 werden beispielsweise eine Laserdiode bzw. ein VCSEL-Bauelement und eine Photodiode eingesetzt. Dadurch, dass diese optoelektronischen Bauelemente 17 in die vorgefertigten Kavitäten 14 eingesetzt werden, anstatt auf dem flexiblen Leiterplattenteil 12 einfach aufgesetzt zu werden, wird die Erzielung einer außerordentlich niedrigen Bauhöhe, insbesondere im Bereich der flexiblen Verbindung zwischen den beiden starren Leiterplattenteilen 11A, 11C, ermöglicht. Durch das "Versenken" der Bauelemente 17 in den Kavitäten 14 des vorgefertigten starr-flexiblen Leiterplattenelements 10 kann nämlich das Lichtemissionsfeld des als Lichtsender fungierenden optoelektronischen Bauelements, beispielsweise das in der Darstellung gemäß Zeichnung linke Bauelement 17, sowie das Lichtdetektionsfeld des Lichtempfänger-Bauelements (z.B. einer Photodiode) sehr knapp über die Kante 18 der Kavität 14 bzw. der obersten flexiblen Lage des -gesonderten- flexiblen Leiterplattenteils 12 gebracht werden. Dies ermöglicht eine minimale Schichtdicke 19 der optischen Schicht 15' über dem gesonderten flexiblen Leiterplattenteil 12, was einerseits zu einer Einsparung an optischem Material sowie vor allem zur Realisierung einer sehr dünnen und dadurch hochflexiblen Schicht 15' führt.

Aus Fig. 1 ist ersichtlich, dass im vorliegenden Ausführungsbeispiel die optoelektronischen Bauelemente 17 mit aufgesetzten Umlenkspiegeln 20 versehen sind, wobei sie nur mit diesen Umlenkspiegeln 20 über die Kanten 18 der Kavitäten 14 ragen. Zwischen diesen Umlenkspiegeln 20 als Lichtabgabeteil bzw. Lichtempfangsteil der optoelektronischen Bauelemente 17 erstreckt sich der durch einen TPA-Prozess strukturierte Licht-Wellenleiter 16, nachstehend auch kurz Lichtleiter 16 genannt. Bei einem derart eingeschriebenen Lichtleiter 16 mit einem beispielsweise kreisförmigen Querschnitt mit einem Durchmesser von beispielsweise 30 µm, und mit verbleibenden durch die übrige optische Schicht 15' gebildeten "Cladding"-Schichten mit einer Dicke von z.B. 35 µm oberhalb und unterhalb des Lichtleiters 16 kann somit eine optische Schicht 15' mit einer Dicke von bloß 100 µm vorgesehen werden. Bei Verwendung einer dünnen, flexiblen Substratfolie als flexibler Substratteil 12, etwa mit einer Dicke von bloß 25 µm, kann daher ein hochflexibler Leiterplattenteil 12' insgesamt, samt integriertem optischen Lichtleiter 16, verwirklicht werden. Durch Anpassung der Dicke der Klebeschicht 13 kann die Höhe der optoelektronischen Bauelemente 17 weiters so ausgeglichen werden, dass das optische Material 15 auf dem gesonderten flexiblen Leiterplattenteil 12 ein Minimum an Dicke erreicht.

Die Dicke der optischen Schicht 15' kann durch eine auf die oberste Schicht des gesonderten flexiblen Leiterplattenteils 12 aufgepresste weitere vorkonfektionierte flexible Rahmenschicht, die einen Rahmen 21 bildet, eingestellt werden. Dieser flexible Rahmen 21 besteht beispielsweise ebenso wie der flexible Leiterplattenteil 12 aus einer Polyimidfolie, und er bildet eine Grenze für das optische Material 15, das bei der Herstellung bevorzugt als viskose Flüssigkeit in die Kavitäten 14 gefüllt und als die Schicht 15' aufgetragen wird, wobei die optoelektronischen Bauelemente 17 praktisch vollständig (sieht man von der Basisfläche ab) eingebettet werden. Der flexible Rahmen 21 kann zur Erhöhung der Flexibilität auch nachträglich wieder entfernt werden.

Anstelle der Verwendung einer Polyimidfolie zur Bildung des flexiblen Rahmens 21 kann auch flüssiges Material (Silikonkautschuk, Polyimidverbindungen, etc.), welches z.B. aufgedruckt oder gespritzt werden kann, auf den flexiblen Leiterplattenteil 12 aufgebracht werden.

Der Rahmen 21 kann vor dem Einsetzen der Bauelemente 17 oder danach aufgebracht werden.

Abschließend kann die optische Schicht 15' noch mit einer - in Fig. 1 nur angedeuteten - flexiblen Decklage oder -schicht 22 geschützt werden, wofür beispielsweise ebenfalls eine Polyimidfolie verwendet werden kann. Diese flexible Decklage 22 schützt die optische Schicht 15' nicht nur mechanisch, sondern auch vor Lichteinstrahlung, um Störungen der Lichtleitung zu unterbinden. Zu diesem Zweck ist die flexible Decklage 22 vorzugsweise gefärbt ausgebildet und in der Lage, von außen einstrahlendes Licht zu absorbieren.

Alternativ zur oben beschriebenen Herstellung unter Anwendung eines flexiblen Rahmens 21 und dem Eingießen des optischen Materials 15 könnte die optische Schicht 15' auch mittels Schablonendruck oder z.B. mittels Inkjet-Technologie aufgebracht werden. Das starre Substrat 11 wird zuerst an den Stellen, an denen es später gebrochen werden soll, an der Oberseite angeritzt. Schließlich wird der flexible Leiterplattenteil 12 beispielsweise aus Polyimid oder flexiblen glasfaserverstärkten Epoxiharzschichten oder dergl. vorkonfektioniert und es werden jene Bereiche, in welchen später Bauelemente eingebracht werden sollen, z.B. durch Herausfräsen, Laserschneiden, Stanzen oder dgl., ausgeschnitten. Der flexible Leiterplattenteil 12 wird mit Hilfe einer Klebeschicht 13 auf dem starren Substrat 11 angebracht und miteinander verpresst.

Das so erhaltene starr-flexible Leiterplattenelement 10 kann auch in weiteren Schritten zu einer Multilayer-Leiterplatte weiterverarbeitet werden.

Die flexible Schicht bzw. der flexible Leiterplattenteil 12' insgesamt kann auch in herkömmlicher Weise Kupferbahnen tragen, was in Fig. 1 nicht näher dargestellt ist, wobei dann diese Kupferbahnen (z.B. zur Stromversorgung) in der optischen Schicht 15' eingebettet und geschützt sind.

In einer alternativen Ausführungsform kann die gesonderte flexible Substratfolie 12 auch weggelassen werden. In diesem Fall werden die Kavitäten 14 vorab in den starren Leiterplattenteilen 11A, 11C gebildet, wobei direkt auf das starre Substrat 11, noch vor Entfernung des Substratteils 11B zur Erzielung des Bereichs B für die flexible Verbindung, das optische Material 15 aufgebracht und der Lichtleiter 16 strukturiert wird. Nach Entfernen des Substratteils 11B im Bereich B wird wiederum ein flexibler Substratteil 12 erhalten, der dann jedoch nur von der optischen Schicht 15' allein gebildet ist.

Nachfolgend werden verschiedene Modifikationen und Weiterbildungen, wie teilweise bereits vorstehend angedeutet, betreffend das vorliegende Leiterplattenelement noch kurz näher anhand der Fig. 2 bis 12 beschrieben.

In Fig. 2 ist insofern ein gegenüber Fig. 1 abgewandeltes Leiterplattenelement 10 gezeigt, als darin die Kavitäten 14 nicht nur im flexiblen Leiterplattenelement 12, sondern auch in den starren Leitenplattenteilen 11A, 11B vorgesehen sind. Die optoelektronischen Bauelemente 17 können dadurch in z-Richtung tiefer in den Aufbau ragen, so dass der flexible Leiterplattenteil 12, der beispielsweise wiederum mittels eines Klebers 13 auf den beiden starren Leiterplattenteilen 11A, 11B aufgeklebt ist, vergleichsweise dünn und/oder jedes Bauelement 17 vergleichsweise hoch sein kann. Weiter ist aus Fig. 2 noch ersichtlich, dass die optoelektronischen Bauelemente 17 mit Hilfe eines nicht leitenden Klebers 23 in den starren Leiterplattenteilen 11A, 11B fixiert sind. Überdies sind auch elektrische Anschlusselemente 24, 25, 26 und 27 der Bauelemente 17 aus Fig. 2 an der Unterseite des Leiterplattenelements 10 erkennbar. Diese Anschlusselemente 24, 25 bestehen beispielsweise aus Kupfer.

Im Übrigen entspricht der Aufbau des Leiterplattenelements 10 gemäß Fig. 2 jenem gemäß Fig. 1, sodass sich eine weitere Erläuterung erübrigen kann, insbesondere da auch bei einander entsprechenden Komponenten entsprechende Bezugszahlen verwendet sind.

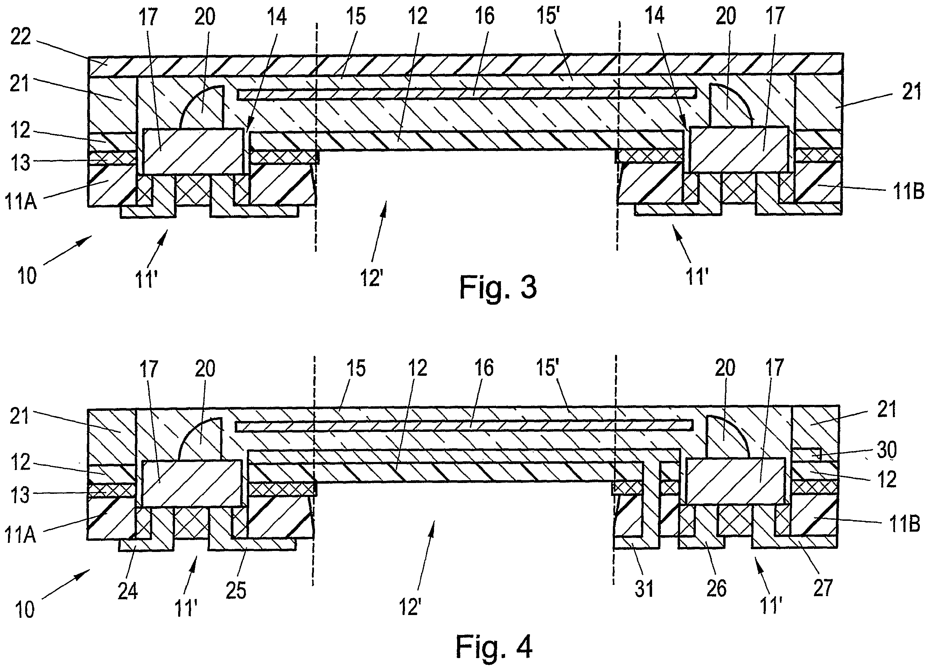

Zur Herstellung eines derartigen Leiterplattenelements 10 gemäß Fig. 2 (und in entsprechender Weise auch des Leiterplattenelements 10 gemäß Fig. 1 bzw. der noch näher zu erläutern Leiterplattenelemente gemäß Fig. 3 ff) kann beispielsweise von einem Trägermaterial 1 mit einer darauf aufkaschierten Kupferschicht 2 ausgegangen werden, wie in Fig. 2A dargestellt ist. Sofern eine unterseitige Kontaktierung der Bauelemente 17 gewünscht ist, werden gemäß Fig. 2B in der Kupferschicht 2 sodann Löcher 3, z.B. durch Laserbohren, gebohrt; diese Löcher 3 werden später zur Kontaktierung (siehe Fig. 2) verwendet. Anschließend wird gemäß Fig. 2C ein Prepreg zur Bildung des Substrats 11 gemäß Fig. 1 und 2 auf das Grundsubstrat 1-2 aufgelegt, wobei im Prepreg zuvor Kavitäten 14' z.B. durch Laserschneiden, Stanzen, Fräsen oder dgl. hergestellt wurden. Danach werden gemäß Fig. 2D Ritzlinien 4 im Prepreg (Substrat 11) an der Oberseite angebracht, um später ein leichtes Abtrennen des Substrat-Mittelteils 11B (vgl. auch Fig. 1) zu ermöglichen.

Wie aus Fig. 2E ersichtlich ist, wird dann ein eigener flexibler Substratteil 12, z.B. eine Polyimidfolie oder ein flexibles Prepreg, mit durch z.B. Laserschneiden, Stanzen, Fräsen etc. hergestellten Kavitäten 14'' mit Hilfe der erläuterten Klebeschicht 13 (z.B. ein konkreter Kleber oder ein vorkonfektioniertes Prepreg) mit dem Prepreg-Substrat 11 verklebt, wobei jedoch der Bereich des heraustrennbaren Substrat-Mittelteils 11B nicht verklebt wird, d.h im Bereich 13B zwischen den Ritzlinien 4 liegt kein Kleber 13 vor.

Gemäß Fig. 2F wird nun der flexible Rahmen 21, beispielsweise in Form eines weiteren flexiblen Substrats, etwa einer Polyimidfolie inkl. einer Klebeschicht (nicht dargestellt), mit entsprechendem freien Innenraum (z.B. durch Laserschneiden, Stanzen, Fräsen, etc. hergestellt), auf den bisherigen Aufbau, insbesondere randseitig auf den flexiblen Leiterplattenteil 12, aufgegeklebt; als Alternative ist auch ein Aufdrucken oder Aufspritzen von flüssigem Material, z.B. Silikonkautschuk oder noch flüssigen Polyimidverbindungen, denkbar, wobei ein entsprechendes Aushärten zur Bildung des flexiblen Rahmens 21 im Anschluss daran erfolgt. Der so erhaltene Aufbau ist nun bereit zur Aufnahme der optoelektronischen Bauelemente 17 in den insgesamt gebildeten Kavitäten 14 sowie des optischen Materials 15 für die Ausbildung des Licht-Wellenleiters 16.

Um die gewünschten optoelektronischen Bauelemente 17 in die Kavitäten 14 einzubringen, werden in letzteren nunmehr gemäß Fig. 2G elektrisch nicht leitende Kleberschichten 23 eingebracht. Als Alternative wäre es aber selbstverständlich auch möglich, dass ein entsprechender Kleber direkt auf die Bauelemente 17 aufgebracht wird. Statt eines flüssig einzubringenden Klebers kann im Übrigen auch ein Klebeband verwendet werden.

Nachfolgend werden die optoelektronischen Bauelemente 17, beispielsweise in einer Form mit aufgesetzten Umlenkspiegeln 20, in die Kavitäten 14 eingesetzt und mit Hilfe der Klebeschichten 23 festgeklebt; vgl. Fig. 2H.

Es sei erwähnt, dass die Bestückung mit den optoelektronischen Bauelementen 17 an sich selbstverständlich auch unmittelbar nach dem Herstellen der Löcher 3 in der Kupferschicht 2, wie in Fig. 2B dargestellt, also noch vor dem Aufbringen der vorkonfektionierten Lagen 11, 12 (mit 13) sowie 21, erfolgen kann.

Nach Erhalt des Aufbaus gemäß Fig. 2H kann das optische Material 15 innerhalb des Rahmens 21 und in die Kavitäten 14 eingebracht werden, wobei das optische Material 15 als Harz oder Gießmasse vorliegt, und wobei die Bauelemente 17 im optischen Material 15 vollständig eingebettet werden, s. Fig. 2I.

In der so erhaltenen optischen Schicht 15' wird dann gemäß Fig. 2J der Licht-Wellenleiter 16 auf die vorstehend beschriebene, an sich bekannte Weise strukturiert, um die gewünschte optische Kommunikationsverbindung zwischen den Bauelementen 17 herzustellen. Falls - je nach optischem Material 15 - eine Aushärtung bzw. Stabilisierung dieses optischen Materials 15 erforderlich ist, kann dieser Schritt nun ebenfalls durchgeführt werden.

Sodann wird gemäß Fig. 2K das ursprüngliche Trägermaterial 1, z.B. eine Trägerfolie, abgezogen, und der Kleber 23 wird in Ausrichtung zu den Bauelement-Kontakten, z.B. 28, entfernt, etwa chemisch bzw. mit Hilfe von Laserstrahlen, durch Plasmaabtragen etc., so dass in Ausrichtung zu den Kontakten 28 Löcher 29 in der Kupferschicht 2 sowie in den Klebeschichten 23 entstehen. Gemäß Fig. 2L wird danach die Kupferschicht 2 strukturiert, und es erfolgt eine Kupfereinbringung in die Löcher 29, so dass die Bauelemente 17 mit den bereits anhand der Fig. 2 erläuterten unteren Kontaktflächen 24, 25, 26 und 27 versehen sind. Es ist dann nur mehr notwendig, den Mittelteil 11B des Substrats 11 bzw. Prepregs herauszutrennen, wonach das in Fig. 2 dargestellte starr-flexible Leiterplattenelement mit der integrierten optischen Verbindung, mit dem Lichtleiter 16, erhalten ist.

In Fig. 3 ist in einer vergleichbaren Schnittdarstellung ein starr-flexibles Leiterplattenelement 10 ähnlich wie in Fig. 2 dargestellt, wobei im Vergleich zu Fig. 2 jedoch zusätzlich eine flexible und beispielsweise auch lichtundurchlässige Deckschicht 22 vorgesehen ist. Diese Deckschicht 22 wird im Verfahrensablauf gemäß den Fig. 2A-2L bevorzugt nach dem Schritt gemäß Fig. 2L, und zwar bevor der mittlere Substratteil 11B entfernt wird, aufgebracht. Die Deckschicht 22 schützt die optische Schicht 15' sowohl mechanisch als auch optisch, im Hinblick auf Störungen durch externe Lichtquellen.

In Fig. 4 ist eine Modifikation des starr-flexiblen Leiterplattenelements 10 gemäß Fig. 2 insofern gezeigt, als der flexible Leiterplattenteil 12 eine bereits strukturierte Kupferlage 30, mit entsprechenden Kupferverbindungen, aufweist, die im fertigen Aufbau somit innen liegen und durch die Einbettung oder Überdeckung durch das optische Material 15 geschützt sind. Es können im Weiteren auch in herkömmlicher Weise Durchverbindungen etwa zur Unterseite des Leiterplattenelements 10 hergestellt werden, wie dies in Fig. 4 beispielhaft bei 31 veranschaulicht ist. Bei dieser Ausführungsform kann der Lichtleiter 16 als Breitbandverbindung zwischen den Bauelementen 17 genützt werden, wobei hiefür keine Abschirmung notwendig ist. Die elektrischen Verbindungen mit Hilfe der Kupferlage 30 können für eine Kommunikation mit niedrigen Datenraten und/oder zur Stromversorgung genützt werden.

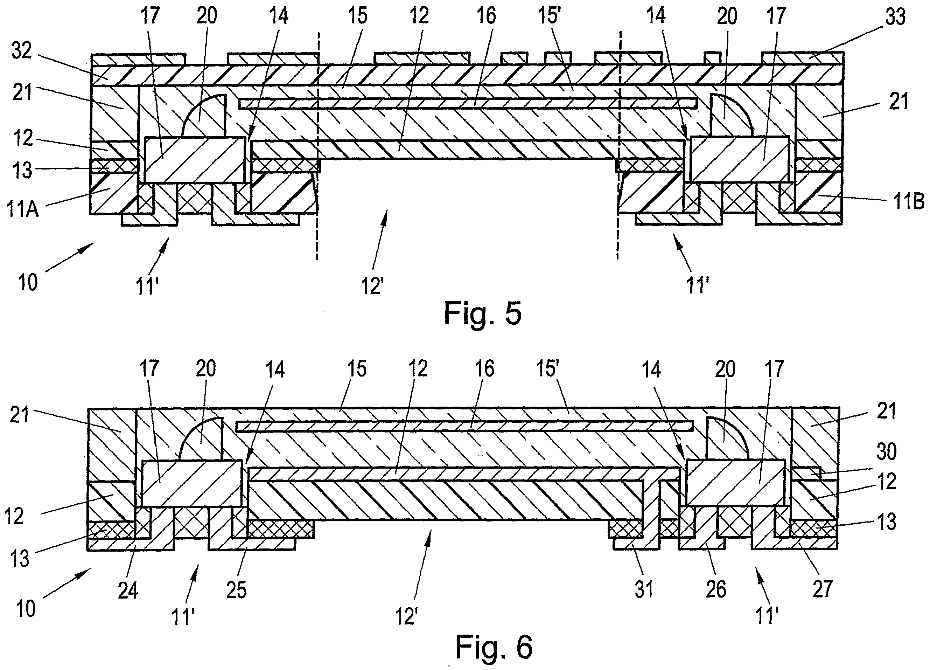

In Fig. 5 ist im Vergleich dazu eine weitere Möglichkeit von elektrischen Verbindungen über Leiterbahnen für ein starr-flexibles Leiterplattenelement 10 gemäß Fig. 2 gezeigt, wobei auf der Oberseite, d.h auf dem Rahmen 21 und auf der optischen Schicht 15', eine weitere flexible Lage 32 mit einer Kupferkaschierung 33 aufgebracht ist. Dies kann beispielsweise nach Erhalt der Zwischenstufe gemäß Fig. 2K durchgeführt werden, wobei danach die Verkupferung und Strukturierung sowie schließlich das Herausbrechen des mittleren Substratteils 11B durchgeführt wird, sodass der Aufbau gemäß Fig. 5 erhalten wird, bei dem eine integrierte optische Verbindung (Lichtleiter 16) sowie eine obenliegende Kupferverbindung - strukturierte Kupferkaschierung 33 - realisiert sind.

Gemäß Fig. 6 kann das Leiterplattenelement 10 auch so aufgebaut sein, dass anfänglich das starre Prepreg bzw. Substrat 11' und somit die starren Leiterplattenteile 11A, 11B weggelassen wird bzw. werden (wobei sich dann auch die Schritte gemäß den Fig. 2C und 2D erübrigen). In diesem Fall hat das Leiterplattenelement 10 von vorneherein keine dezidierten starren Teile, sondern bloß relativ starre Bereiche 11' dort, wo die optoelektronischen Bauelemente 17 vorhanden sind und eine "Starrheit" bewirken, es ist hingegen überall sonst flexibel, vgl. den flexiblen Leiterplattenteil 12' mit dem eigenen biegsamen Leiterplattenteil 12, der ursprünglich über die Klebeschicht 13 auf der Kupferschicht 2 (Fig. 2A) direkt aufgeklebt wurde, bevor diese (siehe Stufe Fig. 2L) zur Bildung der Kontaktflächen 24-27 strukturiert wurde, und mit der flexiblen optischen Schicht 15'. Ein solches Leiterplattenelement 10 gemäß Fig. 6 kann, wie nachfolgend noch näher erläutert wird, danach auf verschiedene Arten mit starren Leiterplattenteilen verbunden werden.

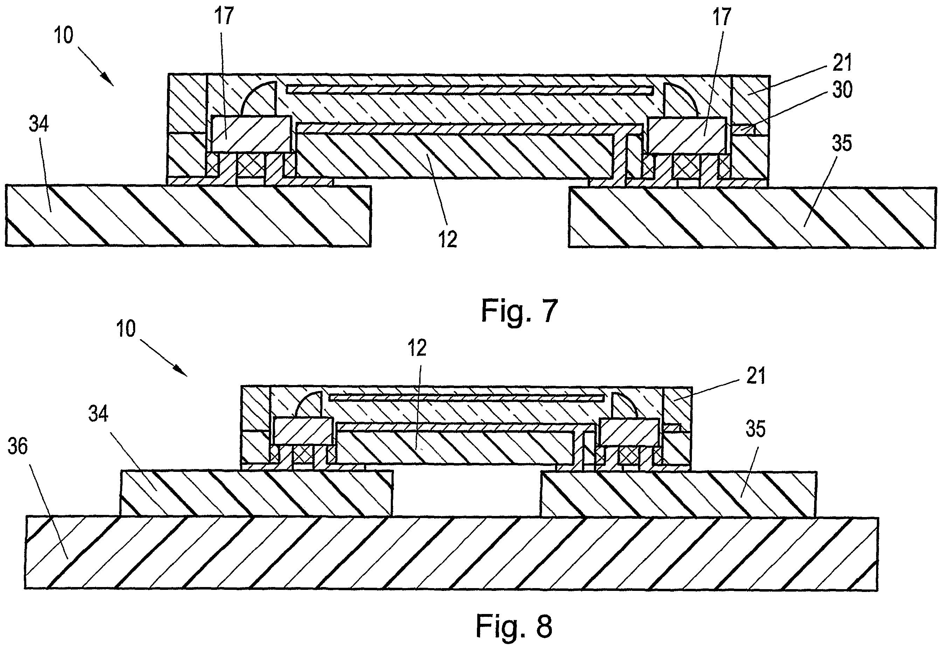

Gemäß Fig. 7 kann ein derartiges Leiterplattenelement 10, wie in den Fig. 2, 3, 4, 5 oder 6 dargestellt (konkret ist in Fig. 7 eine Leiterplattenelement 10 entsprechend Fig. 6 gezeigt), auf weitere Leiterplattenteile 34, 35 aufgesetzt werden, um diese optisch miteinander zu verbinden. Diese Leiterplattenteile 34, 35 sind in Fig. 7 nur ganz schematisch gezeigt, und die Anbindung des Leiterplattenelements 10 an diese Leiterplattenteile 34, 35 kann beispielsweise durch Kleben (beispielsweise mit Hilfe eines anisotropen Leitklebers), durch Löten, durch Drahtbond-Verbindungen, durch Mikrovia-Kontaktierung und dgl. Techniken realisiert werden. Insgesamt kann dann die Anordnung gemäß Fig. 7 als starr-flexible Leiterplattenkombination 34-10-35 angesehen werden. Derartige Leiterplattenmodule können auch erhalten bzw. zusätzlich erweitert werden, wenn die Anordnung auf eine weitere Leiterplatte 36 aufgesetzt wird, wie dies in Fig. 8 gezeigt ist.

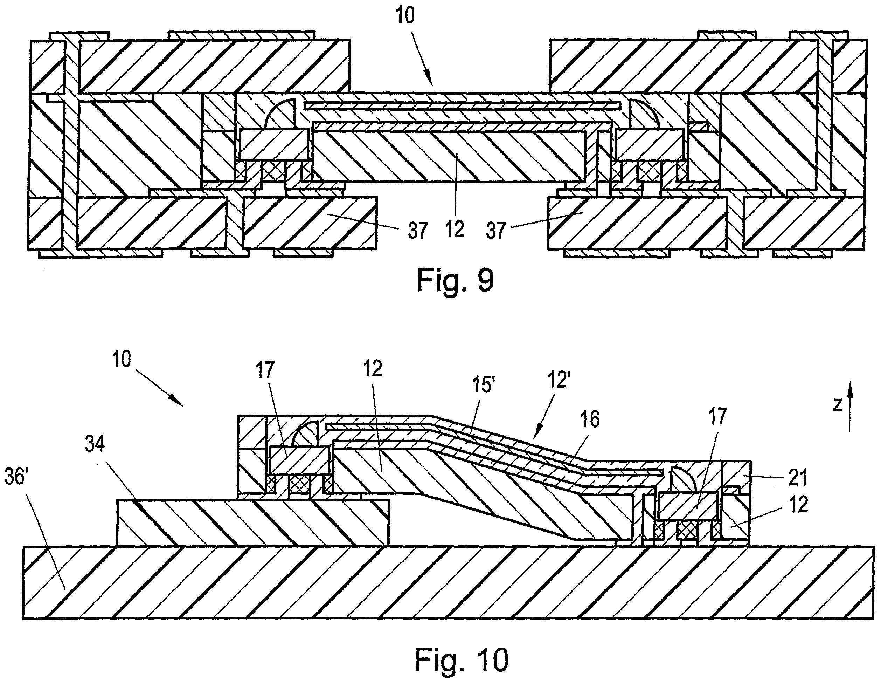

Andererseits ist es selbstverständlich auch möglich, ein starrflexibles Leiterplattenelement 10 wie beschrieben in einer Multilayer-Anordnung einzubauen, d.h in weiteren Leiterplattenlagen einzubetten und mit diesen zu verpressen. Gemäß Fig. 9 ist ein starr-flexibles Leiterplattenelement 10 gezeigt, das in weiteren Leiterplatten 37 eingesetzt und dort kontaktiert wurde, wonach schließlich eine Verpressung zu einer Multilayer-Leiterplatte in herkömmlicher Weise, zu der Anordnung wie schematisch in Fig. 9 gezeigt, erfolgte. Auch hier gilt im Übrigen wieder, ähnlich wie bei den Anordnungen etwa gemäß Fig. 7 und 8, dass auch starrflexible Leiterplattenelemente 10 gemäß den Fig. 1, 2, 3, 4 oder 5, abgesehen von jenem gemäß Fig. 6, wie in den Fig. 7 bis 9 gezeigt, eingesetzt werden können.

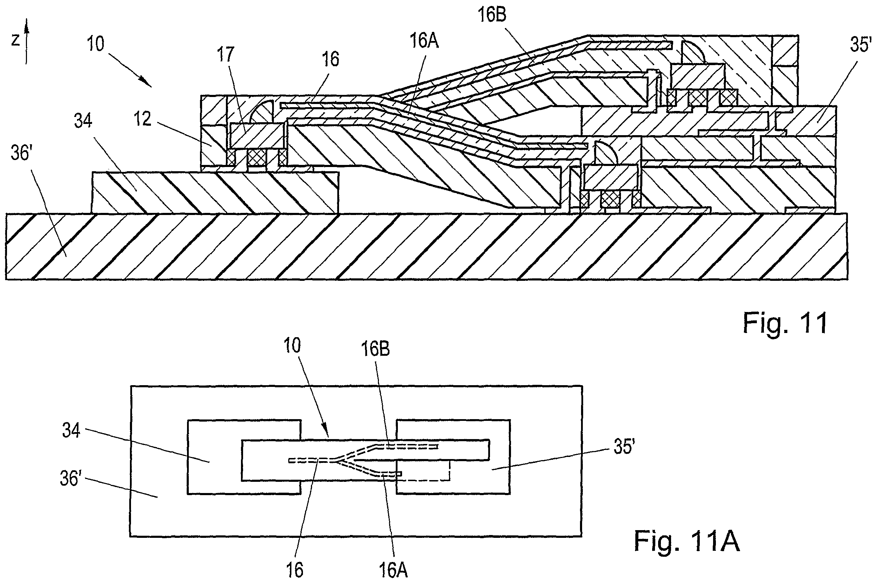

In den Fig. 10 und 11 sind Anwendungen des vorliegenden starr-flexiblen Leiterplattenelements 10 unter Ausnutzung seiner Flexibilität gezeigt. Im Einzelnen ist in Fig. 10 ein starr-flexibles Leiterplattenelement 10 wie vorstehend beispielsweise anhand der Fig. 6 oder aber der Fig. 1, 2, 3, 4 oder 5 beschrieben veranschaulicht, wie es ein Leiterplattenmodul 34 mit einem Motherboard 36' optisch verbinden kann, wobei der flexible Leiterplattenteil 12 mit der optischen Schicht 15' und dem Lichtleiter 16, also der insgesamt gegebene flexible Leiterplattenteil 12', eine Anpassung in z-Richtung vorsieht.

In Fig. 11 und 11A ist eine vergleichbare Anordnung mit einem Motherboard 36' sowie Leiterplattenmodulen 34 und 35' gezeigt, wobei ein Aufzweigungs-Leiterplattenelement 10 mit Zweig-Lichtleitern 16A, 16B durch entsprechendes Ausbiegen (s. Fig. 11) zum Motherboard 36' bzw. zum darüber in an sich herkömmlicher Weise angebrachten Leiterplattenmodul 35' in der Art einer Multilayer-Anordnung führt.

Ganz allgemein können mit Hilfe des vorliegenden Leiterplattenelements 10 die verschiedensten Lichtleitergeometrien realisiert werden, und es können die verschiedensten Module durch die Flexibilität des Leiterplattenelements 10 in veschiedenen z-Höhen miteinander verbunden werden, um so Kommunikationen mit hohen Datenraten direkt zu den gewünschten Endpunkten leiten zu können, ohne den Umweg über herkömmliche elektrische (Kupfer-) Verbindungen gehen zu müssen.

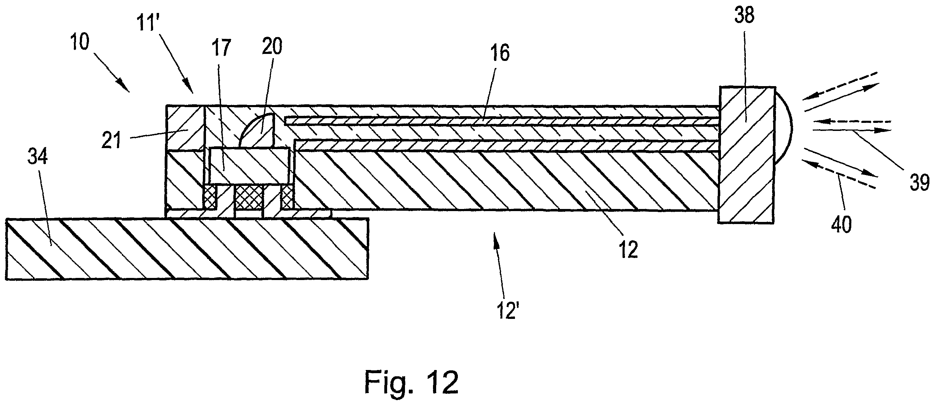

In Fig. 12 ist schließlich eine Anwendung des vorliegenden starr-flexiblen Leiterplattenelements 10 in einer Ausführung mit nur einem optoelektronischen Bauelement 17, beispielsweise wiederum mit Umlenkspiegel 20, gezeigt, wobei dieses Bauelement 17 beispielsweise als Lichtemitter (vgl. auch die Pfeile 39 in Fig. 12), gegebenenfalls aber auch als Lichtdetektor oder Lichtempfänger (vgl. die strichliert gezeichneten Pfeile 40) fungieren kann. Der Licht-Wellenleiter 16 ist beispielhaft über ein Kopfelement 38 zu einem nicht näher gezeigten externen Platz geführt (z.B. um über einen optischen Stecker eine Ankopplung an ein optisches Kabel oder an eine externe Leiterplatte vorzusehen, oder um Licht z.B. als Display-Hintergrundbeleuchtung einsetzen zu können, oder aber für sensorische Anwendungen, etwa wenn einfallendes Licht im Bauelement 17 detektiert wird). Das Bauelement 17 kann im Fall eines Lichtemitters beispielsweise ein VCSEL-Bauelement oder eine LED sein, wogegen es im Fall eines Lichtdetektors beispielsweise durch eine Photodiode oder einen sonstigen Lichtsensor gebildet ist.

Auch hier ist wieder zu berücksichtigen, dass, wenngleich ein Leiterplattenelement 10 gemäß Fig. 6 (allerdings mit nur einem Bauelement 17) in Fig. 12 gezeigt ist, selbstverständlich auch eine Ausbildung etwa gemäß Fig. 1 oder 2 etc. denkbar ist, d.h. mit einem starren Leiterplattenteil 11 im Bereich des optoelektronischen Bauelements 17 (wobei dann der in Fig. 12 gezeigte Leiterplattenteil 34 auch entfallen kann).

Das vorliegende Leiterplattenelement 10 kann selbstverständlich auch noch derart modifiziert werden, dass zusätzlich zu den optoelektronischen Bauelementen 17 auch noch weitere Komponenten im optischen Material 15, insbesondere in den Kavitäten 14, eingebettet werden. So ist es insbesondere denkbar, zusammen mit den optoelektronischen Bauelementen 17 auch elektronische Komponenten, wie einen Treiberchip im Fall eines VCSEL-Bauelements und/oder einen Verstärkerchip im Falle einer Photodiode, als optoelektronische Bauelemente 17 mit einzubauen. Dies ist nur ganz schematisch in Fig. 1 bei 17' veranschaulicht.

## Patentansprüche

1. Starr-flexibles Leiterplattenelement (10) mit zumindest einem flexiblen Leiterplattenteil (12) und mit zumindest einem starren Leiterplattenteil (11A, 11C; 34, 35; 37) mit einem optoelektronischen Bauelement (17), das in einer Kavität (14) untergebracht ist, **dadurch gekennzeichnet, dass** das Bauelement mit einem Lichtabgabe- oder Lichtempfangsteil (20) über die Kante (18) der Kavität (14) ragt, wobei die Kante (18) der Kavität (14) von einer Kavität (14'') in dem flexiblen Leiterplattenteil (12) gebildet wird, und dass der flexible Leiterplattenteil (12) eine flexible Schicht (15, 15'), erhältlich durch Aushärten oder Stabilisieren eines optischen, photopolymerisierbaren Materials aufweist, mit dem die Kavität (14) gefüllt ist und das bis zum Lichtabgabe- oder Lichtempfangsteil (20) des optoelektronischen Bauelements (17) in der Kavität (14) reicht, und in der ein Licht-Wellenleiter (16) in Ausrichtung zum Lichtabgabe- oder Lichtempfangsteil (20) des optoelektronischen Bauelements (17) durch Bestrahlung strukturiert ist.

2. Leiterplattenelement nach Anspruch 1, **dadurch gekennzeichnet dass** der starre Leiterplattenteil (11A, 11C; 34, 35; 37) mit dem zumindest bereichsweise auf ihm aufliegenden flexiblen Leiterplattenteil (12) verbunden ist.

3. Leiterplattenelement nach Anspruch 2, **dadurch gekennzeichnet, dass** die Kavität (14) im Verbindungsbereich des starren und des flexiblen Leiterplattenteils (11A, 11C, 12) vorgesehen ist.

4. Leiterplattenelement nach einem der Ansprüche 1 bis 3, **dadurch gekennzeichnet, dass** ein gesonderter flexibler Leiterplattenteil (12) auf dem starren Leiterplattenteil (11A, 11C) mit Hilfe einer Klebeschicht (13) angebracht ist.

5. Leiterplattenelement nach einem der Ansprüche 1 bis 4 **dadurch gekennzeichnet, dass** die Kavität (14) im flexiblen Leiterplattenteil (12) direkt an den starren Leiterplattenteil (11A, 11C) anschließt.

6. Leiterplattenelement nach Anspruch 4 und 5, **dadurch gekennzeichnet, dass** die Kavität (14) auch in der Klebeschicht (13) vorgesehen ist.

7. Leiterplattenelement nach einem der Ansprüche 1 bis 3, 5 oder 6, **dadurch gekennzeichnet, dass** der flexible Leiterplattenteil (12) durch die flexible Schicht (15') des optischen Materials (15) gebildet ist.

8. Leiterplattenelement nach einem der Ansprüche 1 bis 7, **dadurch gekennzeichnet, dass** das optoelektronische Bauelement (17) mit einem aufgesetzten Umlenkspiegel (20) ausgebildet ist.

9. Leiterplattenelement nach Anspruch 8, **dadurch gekennzeichnet, dass** das optoelektronische Bauelement (17) nur mit dem Umlenkspiegel (20) über die Kante (18) der Kavität (14) ragt, selbst jedoch vollständig innerhalb der Kavität (14) untergebracht ist.

10. Leiterplattenelement nach einem der Ansprüche 1 bis 9, **dadurch gekennzeichnet, dass** das optoelektronische Bauelement (17) ein VCSEL-Bauelement ist.

11. Leiterplattenelement nach einem der Ansprüche 1 bis 10, **dadurch gekennzeichnet, dass** das optoelektronische Bauelement (17) in der Kavität (14) vom durch Aushärten oder Stabilisieren erhältlichen optischen, photopolymerisierbaren Material (15) umgeben ist.

12. Leiterplattenelement nach einem der Ansprüche 1 bis 11, **dadurch gekennzeichnet, dass** die flexible, durch Aushärten oder Stabilisieren eines optischen, photopolymerisierbaren Materials (15) erhältlichen Schicht (15') von einem flexiblen Rahmen (21) umgeben ist.

13. Leiterplattenelement nach Anspruch 12, **dadurch gekennzeichnet, dass** der flexible Rahmen (21) aus einer Polyimidfolie gebildet ist.

14. Leiterplattenelement nach einem der Ansprüche 1 bis 13, **dadurch gekennzeichnet, dass** die flexible, durch Aushärten oder Stabilisieren eines optischen, photopolymerisierbaren Materials (15) erhältlichen Schicht (15') von einer flexiblen Decklage (22) bedeckt ist.

15. Leiterplattenelement nach einem der Ansprüche 2 bis 14, **dadurch gekennzeichnet, dass** zumindest zwei starre Leiterplattenteile (11A, 11C; 34, 35; 37) in Abstand voneinander vorgesehen sind, deren Abstand vom flexiblen Leiterplattenteil (12) überbrückt ist, wobei auf jedem starren Leiterplattenteil (11A, 11C) ein optoelektronisches Bauelement (17) in einer Kavität (14) angeordnet ist und sich der Licht-Wellenleiter (16) zwischen den beiden optoelektronischen Bauelementen (17) erstreckt.

16. Verfahren zum Herstellen eines Leiterplattenelements (10) nach einem der Ansprüche 1 bis 15, **dadurch gekennzeichnet, dass** der flexible Leiterplattenteil (12) nach einer Vorkonfektionierung, wobei zumindest die Kavität (14'') in ihm angebracht wurde, auf dem zumindest einen starren Leiterplattenteil (10A, 10B; 34, 35; 37) angebracht wird.

17. Verfahren nach Anspruch 16, **dadurch gekennzeichnet, dass** die durch Aushärten oder Stabilisieren eines optischen, photopolymerisierbaren Material flexible Schicht (15, 15') erhältlichen erst nach dem Anbringen des flexiblen Leiterplattenteils (12) auf dem starren Leiterplattenteil (10A, 10B) aufgebracht wird, wonach der Licht-Wellenleiter (16) darin strukturiert wird.

## Claims

1. Rigid-flexible printed circuit board element (10) with at least one flexible printed circuit board portion (12) and with at least one rigid printed circuit board portion (11A, 11C; 34, 35; 37) with an optoelectronic component (17) housed in a cavity (14), **characterized in that** the component (17) projects over the edge (18) of the cavity (14) with a light-emitting or light-receiving part (20), wherein the edge (18) of the cavity (14) is formed by a cavity (14'') in the flexible printed circuit board portion (12), and **in that** the flexible printed circuit board portion (12) has a flexible layer (15, 15') obtainable by curing or stabilizing of an optical, photo-polymerizable material, with which the cavity (14) is filled and which reaches up to the light-emitting or light-receiving part (20) of the optoelectronic component (17) in the cavity (14), and in which an optical waveguide (16) is structured in alignment with the light-emitting or light-receiving part (20) of the optoelectronic component (17) by means of radiation.

2. Printed circuit board element according to Claim 1, **characterized in that** the rigid printed circuit board portion (11A, 11C; 34, 35; 37) is connected to the flexible printed circuit board portion (12) that rests on the rigid printed circuit board portion at least in some regions.

3. Printed circuit board element according to Claim 2, **characterized in that** the cavity (14) is provided in the connecting region of the rigid and the flexible printed circuit board portions (11A, 11C, 12).

4. Printed circuit board element according to any one of Claims 1 to 3, **characterized in that** a separate, flexible printed circuit board portion (12) is applied on the rigid printed circuit board portion (11A, 11C) with the aid of an adhesive layer (13).

5. Printed circuit board element according to any one of Claims 1 to 4, **characterized in that** the cavity (14) in the flexible printed circuit board portion (12) directly adjoins the rigid printed circuit board portion (11A, 11C).

6. Printed circuit board element according to Claims 4 and 5, **characterized in that** the cavity (14) is also provided in the adhesive layer (13).

7. Printed circuit board element according to any one of Claims 1 to 3, 5 or 6, **characterized in that** the flexible printed circuit board portion (12) is formed by the flexible layer (15') of the optical material (15).

8. Printed circuit board element according to any one of Claims 1 to 7, **characterized in that** the optoelectronic component (17) is configured with a deflection mirror (20) put thereupon.

9. Printed circuit board element according to Claim 8, **characterized in that** the optoelectronic component (17) projects over the edge (18) of the cavity (14) only with the deflection mirror (20), with the optoelectronic component itself being completely housed within the cavity (14), however.

10. Printed circuit board element according to any one of Claims 1 to 9, **characterized in that** the optoelectronic component (17) is a VCSEL component.

11. Printed circuit board element according to any one of Claims 1 to 10, **characterized in that** the optoelectronic component (17) is surrounded in the cavity (14) by the optical, photo-polymerizable material (15) obtainable by curing or by stabilizing.

12. Printed circuit board element according to any one of Claims 1 to 11, **characterized in that** the flexible layer (15') obtainable by curing or stabilizing of an optical, photo-polymerizable material (15) is surrounded by a flexible frame (21).

13. Printed circuit board element according to Claim 12, **characterized in that** the flexible frame (21) is formed by a polyimide film.

14. Printed circuit board element according to any one of Claims 1 to 13, **characterized in that** the flexible layer (15') obtainable by curing or stabilizing of an optical, photo-polymerizable material (15) is covered by a flexible cover layer (22).

15. Printed circuit board element according to any one of Claims 2 to 14, **characterized in that** at least two rigid printed circuit board portions (11A, 11C; 34, 35; 37) are provided at a distance from one another, said distance being bridged by the flexible printed circuit board portion (12), an optoelectronic component (17) being arranged in a cavity (14) on each rigid printed circuit board portion (11A, 11C), and the optical waveguide (16) extending between the two optoelectronic components (17).

16. Method of producing a printed circuit board element (10) according to any one of Claims 1 to 15, **characterized in that** the flexible printed circuit board portion (12), after preassembly, where at least the cavity (14'') has been applied to it, is mounted on the at least one rigid printed circuit board portion (10A, 10B; 34, 35; 37).

17. Method according to Claim 16, **characterized in that** the flexible layer (15, 15') obtainable by curing or stabilizing of an optical, photo-polymerizable material is only applied after the flexible printed circuit board portion (12) has been applied on the rigid printed circuit board part (10A, 10B), whereafter the optical waveguide (16) is structured therein.

## Revendications

1. Elément de carte de circuits imprimés rigide-flexible (10) comprenant au moins une partie de carte de circuits imprimés flexible (12) et au moins une partie de carte de circuits imprimés rigide (11A, 11C ; 34, 35 ; 37) présentant un composant optoélectronique (17), qui est placé dans une cavité (14), **caractérisé en ce que** le composant fait saillie par une partie d'émission ou de réception de lumière (20) du bord (18) de la cavité (14), dans lequel le bord (18) de la cavité (14) est formé par une cavité (14'') dans la partie de carte de circuits imprimés flexible (12), et **en ce que** la partie de carte de circuits imprimés flexible (12) comprend une couche flexible (15, 15'), pouvant être obtenue par durcissement ou stabilisation d'un matériau optique photopolymérisable, dont la cavité (14) est remplie et qui parvient dans la cavité (14) jusqu'à la partie d'émission ou de réception de lumière (20) du composant optoélectronique (17), et dans laquelle un guide d'ondes optiques (16) est structuré par exposition à un rayonnement dans une orientation dirigée vers la partie d'émission ou de réception de lumière (20) du composant optoélectronique (17).

2. Elément de carte de circuits imprimés selon la revendication 1, **caractérisé en ce que** la partie de carte de circuits imprimés rigide (11A, 11C ; 34, 35 ; 37) est reliée à la partie de carte de circuits imprimés flexible (12) reposant sur celle-ci au moins par endroits.

3. Elément de carte de circuits imprimés selon la revendication 2, **caractérisé en ce que** la cavité (14) est ménagée dans la zone de liaison des parties de carte de circuits imprimés rigide et partie de carte de circuits imprimés flexible (11A, 11C, 12).

4. Elément de carte de circuits imprimés selon l'une quelconque des revendications 1 à 3, **caractérisé en ce qu'**une partie de carte de circuits imprimés flexible (12) distincte est fixée sur la partie de carte de circuits imprimés rigide (11A, 11C) à l'aide d'une couche de colle (13).

5. Elément de carte de circuits imprimés selon l'une quelconque des revendications 1 à 4, **caractérisé en ce que** la cavité (14) dans la partie de carte de circuits imprimés flexible (12) est directement adjacente à la partie de carte de circuits imprimés rigide (11A, 11C).

6. Elément de carte de circuits imprimés selon les revendications 4 et 5, **caractérisé en ce que** la cavité (14) est également ménagée dans la couche de colle (13).

7. Elément de carte de circuits imprimés selon l'une quelconque des revendications 1 à 3, 5 ou 6, **caractérisé en ce que** la partie de carte de circuits imprimés flexible (12) est formée par la couche flexible (15') du matériau optique (15).

8. Elément de carte de circuits imprimés selon l'une quelconque des revendications 1 à 7, **caractérisé en ce que** le composant optoélectronique (17) est pourvu d'un miroir de renvoi (20) dressé.

9. Elément de carte de circuits imprimés selon la revendication 8, **caractérisé en ce que** le composant optoélectronique (17) ne fait saillie du bord (18) de la cavité (14) que par le miroir de renvoi (20), mais est placé intégralement à l'intérieur de la cavité (14).

10. Elément de carte de circuits imprimés selon l'une quelconque des revendications 1 à 9, **caractérisé en ce que** le composant optoélectronique (17) est un composant de laser à cavité verticale émettant par la surface.

11. Elément de carte de circuits imprimés selon l'une quelconque des revendications 1 à 10, **caractérisé en ce que** le composant optoélectronique (17) est entouré dans la cavité (14) d'un matériau optique photopolymérisable (15) pouvant être obtenu par durcissement ou stabilisation.

12. Elément de carte de circuits imprimés selon l'une quelconque des revendications 1 à 11, **caractérisé en ce que** la couche flexible (15') pouvant être obtenue par durcissement ou stabilisation d'un matériau optique photopolymérisable (15) est entourée par un cadre flexible (21).

13. Elément de carte de circuits imprimés selon la revendication 12, **caractérisé en ce que** le cadre flexible (21) est formé à partir d'un film de polyimide.

14. Elément de carte de circuits imprimés selon l'une quelconque des revendications 1 à 13, **caractérisé en ce que** la couche flexible (15') pouvant être obtenue par durcissement ou stabilisation d'un matériau optique photopolymérisable (15) est recouverte d'une couche de revêtement flexible (22).

15. Elément de carte de circuits imprimés selon l'une quelconque des revendications 2 à 14, **caractérisé en ce qu'**au moins deux parties de carte de circuits imprimés rigides (11A, 11C ; 34, 35 ; 37) sont prévues à distance l'une de l'autre, et leur écart est couvert par la partie de carte de circuits imprimés flexible (12), dans lequel un composant optoélectronique (17) est agencé dans une cavité (14) sur chaque partie de carte de circuits imprimés rigide (11A, 11C) et le guide d'ondes optiques (16) s'étend entre les deux composants optoélectroniques (17).

16. Procédé de fabrication d'un élément de carte de circuits imprimés (10) selon l'une quelconque des revendications 1 à 15, **caractérisé en ce que** la partie de carte de circuits imprimés flexible (12) est fixée sur les au moins une partie de carte de circuits imprimés rigides (10A, 10B ; 34, 35 ; 37) après une préfabrication, dans lequel au moins la cavité (14'') a été ménagée sur ladite partie de carte de circuits imprimés flexible.

17. Procédé selon la revendication 16, **caractérisé en ce que** la couche flexible (15, 15') pouvant être obtenue par durcissement ou stabilisation d'un matériau optique photopolymérisable n'est appliquée qu'après la fixation de la partie de carte de circuits imprimés flexible (12) sur la partie de carte de circuits imprimés rigide (10A, 10B), à la suite de quoi le guide d'ondes optiques (16) est structuré dans ladite couche.
